(19)

Europäisches
Patentamt
European
Patent Office
Office européen
des brevets

(11) **EP 4 400 625 A1**

(12) **EUROPEAN PATENT APPLICATION**

(43) Date of publication:
**17.07.2024   Bulletin 2024/29**

(21) Application number: **23151545.3**

(22) Date of filing: **13.01.2023**

(51) International Patent Classification (IPC):
*C23C 14/04* (2006.01)     *C23C 14/54* (2006.01)
*C23C 14/26* (2006.01)     *C23C 14/28* (2006.01)
*C23C 14/16* (2006.01)     *C23C 14/08* (2006.01)
*B33Y 10/00* (2015.01)     *B33Y 30/00* (2015.01)
*B29C 64/00* (2017.01)     *H05K 3/04* (2006.01)
*H01L 21/26* (2006.01)     *H01L 23/00* (2006.01)
*B23K 26/00* (2014.01)     *H05K 1/09* (2006.01)
*H05K 3/40* (2006.01)

(52) Cooperative Patent Classification (CPC):
**B29C 64/141; B23K 26/00; B29C 64/268;**
**B33Y 10/00; B33Y 30/00; H01L 24/00;**
**H05K 3/046;** H01L 33/0095; H05K 1/097;
H05K 3/403; H05K 2203/0338; H05K 2203/0528;
H05K 2203/066; H05K 2203/1105

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Nederlandse Organisatie voor**
**toegepast-natuurwetenschappelijk Onderzoek**
**TNO**
**2595 DA 's-Gravenhage (NL)**

(72) Inventors:
• **Bruning, Fabien Jacques**
  **2595 DA's-Gravenhage (NL)**
• **Hendriks, Rob Jacob**
  **2595 DA's-Gravenhage (NL)**

(74) Representative: **V.O.**
   **P.O. Box 87930**
   **2508 DH Den Haag (NL)**

(54) **DEPOSITION APPARATUS, METHOD FOR DEPOSITING, METHOD FOR PACKAGING A DIE IN A CHIP PACKAGE**

(57)     A deposition apparatus (1) for depositing materials (Ma, Mb, ..., Mn) on a target (T) is provided herein. The apparatus is configured to initiate ejection of a material portion from an ejection position of a donor plate (2) at a point in time that a spatial vector defined between the deposition position ($p_s$) and the ejection position ($p_e$) corresponds to a movement of the donor plate (2) relative to the target (T). Also a corresponding deposition method is provided.

FIG. 1

EP 4 400 625 A1

## Description

BACKGROUND

The present invention pertains to a deposition apparatus for depositing materials on a target.

The present invention further pertains to a method for depositing materials on a target.

Additive manufacturing of multi-material functional parts is an attractive production method for fabrication of devices, e.g. electronic devices, microLED displays as well as for chip packaging. In volume production, overlay control at high speeds for multiple layers on a substrate is a continuing challenge. A promising technology for this application is so called Impulse PrintingTM. This technology provides for a rapid heating of a surface carrying a substance to be deposited. Upon said rapid heating, a portion of the substance in contact with the heated surface is evaporated and the resulting vapor pressure pushes the remaining, non-evaporated portion towards the target where it is to be deposited.

There is a need to further develop this technology to enable an efficient deposition of mutually different materials, optionally to form a stack on the target surface.

SUMMARY

In accordance with a first aspect of the present disclosure an improved deposition apparatus for depositing materials on a target is provided.

In accordance with a second aspect of the present disclosure an improved method for depositing materials on a target is provided.

The improved deposition apparatus according to the first aspect is defined in claim 1.

Embodiments of the improved deposition apparatus comprise a donor plate, a heater facility, a carrier, a displacement unit, a storage unit, and a controller.

The donor plate has a first main surface with respective donor material zones for said materials.

The heater facility is provided for locally heating the donor plate. The heater facility is for example a resistive heater layer integrated in the donor plate or a photon radiation source to irradiate the donor plate or a material present thereon, e.g. a flash light or a laser. Upon heating a location of the donor plate, a specimen of the donor material present at that location on the first main surface is heated to a temperature that causes evaporation of a portion of that specimen in contact with the main surface. The resulting vapor pressure causes a transfer of the remainder of the specimen to the towards the target.

The carrier carries the target with a target surface facing the first main surface of the donor plate at a gap distance thereof, so that the remaining specimen is deposited on the target surface.

The displacement unit is configured for displacing the carrier and the donor plate relative to each other, for example by displacing the carrier or by displacing the donor plate or displacing both.

The storage unit is configured for storing a deposition schedule that specifies a deposition pattern of deposition positions where the material portions are to be deposited on the target surface.

The controller is provided for controlling the heater facility and the displacement unit and is configured to read the deposition schedule and to perform the following sub-steps for each material portion to be deposited.

> 1) determining an ejection position of the donor plate where the material portion to be deposited is present,
> 2) determining a velocity of a relative movement between the donor plate and the target,
> 3) computing a resulting relative movement occurring in a time interval wherein the ejected material traverses the gap distance based on said velocity and a velocity with which said material is ejected,
> 4) initiating ejection of the material portion from the ejection position of the donor plate at a point in time that a spatial vector defined between the deposition position (ps) and the ejection position (pe) corresponds to the relative movement.

In some embodiments one or more of the steps 1,2 and 3 is performed in advance for the complete deposition schedule, and subsequently step 4 can be performed to implement the deposition schedule by ejecting material portions from the ejection positions of the donor plate at the respective points in time as determined in advance in steps 1,2,3.

In other embodiments, the steps 1,2,3 are performed on the fly. That is while in step 4 a material portion is being deposited, steps 1,2 and 3 are performed for deposition of subsequent material portions.

Still further hybrid approaches are possible, wherein the computations are partly performed beforehand and partly while performing deposition. For example, the expected velocity with which the material portion is ejected can be computed beforehand and stored as input value in the computation step. As an other example all steps 1,2 and 3 are performed in advance for the complete deposition schedule, but in addition, during deposition, the computation results are fine-tuned to take into account measured deviations of the relative movement.

The improved deposition method according to the second aspect comprises the following steps.

A deposition schedule is provided that specifies a pattern of deposition positions where material portions of materials are to be deposited on a target surface of the target.

A donor plate is provided that has a first main surface cladded with the materials to be deposited. The first main surface of the donor plate may be partitioned into a respective zone for each of the materials of which a portion is to be deposited. Alternatively, the first main surface of the donor plate may comprise a zone with a plurality of material species, which may be of a mutually different composition. In case the donor plate has a predetermined partitioning for the materials to be deposited, it can be provided before the deposition schedule.

Subsequently, the target and the donor plate are moved relative to each other such that a target surface of the target faces the first main surface of the donor plate at a gap distance thereof.

While moving the donor plate and the target relative to each other an area of the donor plate is rapidly heated so as to eject material present within said zone on the first main surface towards the target surface. In one example the zone is uniformly cladded with a single material. For example, the first main surface is partitioned into respective sections that each are cladded with a respective material and the zone that is heated is a portion of a section. Upon rapidly heating the donor plate, the material present in that zone is ejected. Alternatively or additionally, the zone of the first main surface of the donor plate that is rapidly heated may be provided with a plurality of mutually distinct material species, which may have a different material composition. Upon rapidly heating the zone the mutually distinct material species are simultaneously ejected. In an embodiment, rapidly heating the donor plate is achieved by resistively heating. In another embodiment rapidly heating is achieved by irradiation with photon radiation, for example with a laser beam or a flash light. To that end, the donor plate may be provided with a photon radiation absorbing layer. Alternatively, rapid heating may be achieved by absorption of the photon radiation in the material to be deposited.

In this procedure the position from which material is to be ejected by rapidly heating as a function of time while performing said relative movement is determined as follows.

For each material portion to be deposited the following sub-steps are performed:

> determining an ejection position of the donor plate where the material to be deposited is present;
> determining a velocity of a relative movement between the donor plate and the target;
> computing a resulting relative movement occurring in a time interval wherein the ejected material traverses the gap distance;
> ejecting the material from the ejection position of the donor plate at a point in time that a spatial vector defined between the deposition position and the ejection position corresponds to the relative movement.

Typically the steps of determining and computing are performed in advance, before performing the actual deposition process. Alternatively these steps may be performed during the deposition process. For example, while depositing one or more pattern elements, computations may be performed to schedule the timing of deposition of subsequent material species. Also feedback computations may be performed to fine-tune the timing of ejection.

BRIEF DESCRIPTION OF THE DRAWINGS

These and other aspects of the present disclosure are described in more detail with respect to the drawings. Therein:

> FIG. 1 schematically shows an overview of an embodiment of the improved deposition apparatus;
> FIG. 2A and 2B schematically show an overview of another embodiment of the improved deposition apparatus, therein FIG. 2B illustrates a stage in de deposition process in a cross-section BB indicated in FIG. 2A;
> FIG. 3 shows aspects of a further embodiment of the improved deposition apparatus;
> FIG. 4 shows an exemplary product obtainable with the improved deposition apparatus;
> FIG. 5A - 5C illustrate a method not according to the present invention;
> FIG. 6A - 6C illustrate an embodiment of the improved deposition method;
> FIG. 7A, 7B and FIG. 8A, 8B show an application of the improved device and/or method.
> FIG. 9A-9D illustrate a calibration method;
> FIG. 10A, 10B and 10C illustrate an alternative calibration method;
> FIG. 11 schematically shows an overview of the improved deposition method;
> FIG. 12 shows exemplary examples of a first main surface or portion thereof of a donor plate provided with materials to be deposited;
> FIG. 13 shows a further application;
> FIG. 14 shows another application

DETAILED DESCRIPTION OF EMBODIMENTS

Like reference symbols in the various drawings indicate like elements unless otherwise indicated.

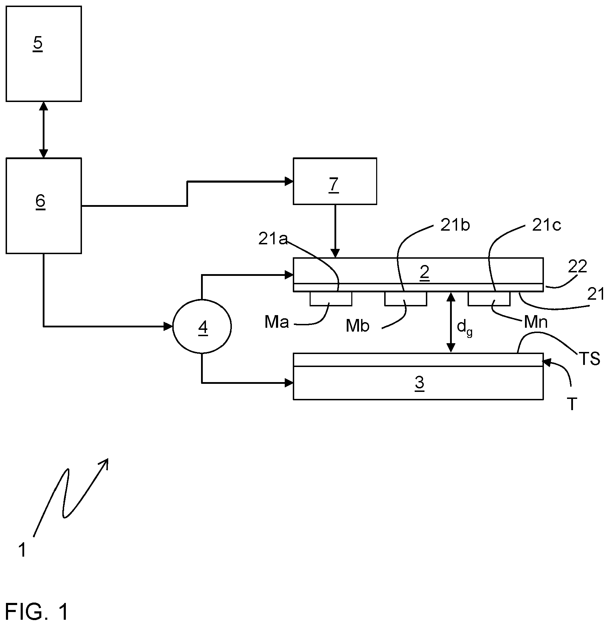

FIG. 1 shows an overview of an embodiment of the improved deposition apparatus 1 for depositing materials Ma, Mb, ..., Mn on a target T. As shown in FIG. 1, the device 1 comprises a donor plate 2, a heater facility 22, a carrier 3, a displacement unit 4, a storage unit 5 and a controller 6.

The donor plate 2 has a first main surface 21 with a donor material zone 21a, 21b,..., 21n for donor materials Ma, Mb, ..., Mn. Suitable donor materials are inks or pasts comprising a functional agent dissolved in a solvent or suspended in a suspension agent. The donor materials typically have a viscosity in the range between 10 and 5000 Pa*s, typically in the range of 100 to 1000 Pa*s.

The functional agent can be any component intended for a particular purpose in the workpiece to be provided on the target surface. For example a suspension of metal particles, e.g. a copper ink, a silver ink or a carbon ink can serve to print an electrically conductive element on the target surface. Also a solder is suitable for that purpose. In an example the solder has a solids content formed by 85±5 wt% of a metal alloy, such as SAC305, 5-15 % of an oxide removing agent and component to improve printability. Also metal complex inks are suitable for the purpose of forming electrically connecting elements. For the purpose of forming electrically insulating or thermally insulating elements, a suspension or a solution of ceramic material, such as silicon oxide, silicon nitride, titanium oxide, aluminum oxide is suitable. Other examples are adhesive inks to form an adhesive element on the target, for example a component, an underfill material that forms an underfill at the target location.

The heater facility 22 is provided for locally heating the donor plate 2. In the example shown, the heater facility is a resistive heater layer 22 integrated in the donor plate 2 that is coupled to a power supply unit 7.

The carrier 3 is provided for carrying the target T, so that its target surface TS faces the first main surface 21 of the donor plate 2 at a gap distance thereof.

The displacement unit 4 is provided for displacing the carrier 3, with the target T relative to the donor plate 2 relative to each other. The relative displacement can be achieved, by a displacement of the carrier with the target T, a displacement of the donor plate 2 or combination thereof. For example, the displacement unit 4 may be configured to displace the carrier 3 in a first lateral direction and the donor plate 2 in a second lateral direction transverse to the first lateral direction. In an embodiment the displacement unit 4 is further configured to control the gap distance between the target surface TS of the target and the first main surface 21 of the donor plate 2. In some embodiments the displacement unit 4 is configured to change a relative orientation between the target surface TS of the target and the first main surface 21 of the donor plate 2.

The storage unit 5 is provided for storing a deposition schedule that specifies a pattern of deposition positions $p_s$ where material portions of said materials Ma, Mb, ..., Mn are to be deposited on the target surface TS. This can be any storage medium like a hard disk, a flash memory and the like or a RAM in which the deposition schedule is downloaded from an external data source.

The controller 6 is provided for controlling the heater facility 22 and the displacement unit 4 and is configured to read the deposition schedule and to perform the following steps for each material portion to be deposited:
The controller determines an ejection position $p_e$ of the donor plate 2 where the material portion to be deposited is present.

The controller determines a velocity $v_{dt}$ of a relative movement between the donor plate 2 and the target T.

The controller computes a resulting relative movement ∆l occurring in a time interval wherein the ejected material portion traverses the gap distance dg based on the velocity $v_{dt}$ and a velocity with which the material portion is ejected. It suffices that the controller computes the ejection velocity of a material portion once. Subsequently, the computed value for the ejection velocity can be used for further calculations. The ejection velocity depends on various circumstances, such as material properties of the donor material, like a specific weight, a viscosity, an evaporation temperature of a solvent used therein, as well as the power density with which the first main surface of the donor plate is heated. Also the ejection velocity depends on whether the donor material is ejected as a lateral portion of a donor layer, or as an isolated piece of material. Further the ejection velocity depends on a thickness of the piece of material or of the layer from which it is ejected. Although there are many dependencies, the ejection velocity can be easily determined in a calibration step for a predetermined set of conditions and for deviation conditions the ejection velocity can be estimated by interpolation.

While the donor plate 2 and the target move relative to each other in a controlled manner the controller initiates ejection of a material portion from the ejection position of the donor plate 2 at a point in time that a spatial vector defined between the deposition position $p_s$ and the ejection position $p_e$ corresponds to the relative movement. To that end the controller causes the heater facility 22 to locally heat the donor plate at the ejection position $p_e$. Therewith a specimen of the donor material present at that location on the first main surface is heated to a temperature that causes evaporation of a portion of that specimen in contact with the main surface. The resulting vapor pressure causes a transfer of the material portion constituted by the remainder of the specimen at the ejection position $p_e$ towards the target.

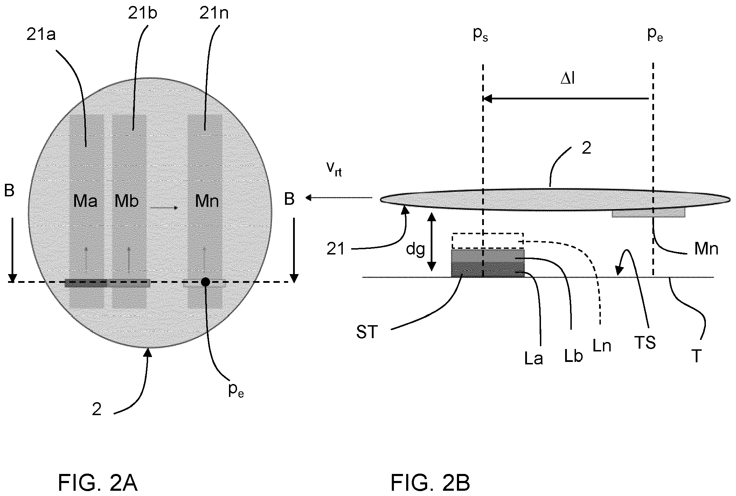

In some embodiments the deposition pattern not only specifies the deposition positions ps where material portions of the materials Ma, Mb, ..., Mn are to be deposited on the target surface TS, but also specifies an order in which material portions are to be stacked on the target surface TS and the controller 5 is configured to control the deposition apparatus to perform deposition in the specified order. This is illustrated in FIG. 2A, 2B. FIG. 2A shows the first main surface 21 of an exemplary donor plate 2. FIG. 2B illustrates a stage in de deposition process. It shows the donor plate 2 opposite the target T with the plate in a cross-section BB indicated in FIG. 2A.

In the stage shown in FIG. 2B, the deposition device 1 has already partially completed deposition of a stack on the location indicated by ps on the target surface TS. The already deposited layers of the stack on the indicated deposition position comprise a first layer La of the material Ma and a second layer of the material Mb. In FIG. 2B it is shown that the donor plate 2 moves with a velocity $v_r$ in the direction indicated by the arrow.

The controller computes a resulting relative

movement $\Delta l$ occurring in a time interval wherein the ejected material portion traverses the gap distance $d_g$ based on the velocity $v_r$ and a velocity $v_m$ with which the material portion is ejected with the following equation.

$$\Delta l = \frac{v_r}{v_m} d_g$$

Upon determining that that a spatial vector defined between the deposition position $p_s$ and the ejection position $p_e$ corresponds to the relative movement $\Delta l$ the controller causes the heater facility 22 to locally heat the donor plate 2 at the position $p_e$ to initiate ejection of the material portion from that position. After having traversed the gap distance dg, the ejected material portion Mn forms a further layer Ln on the stack at position ps.

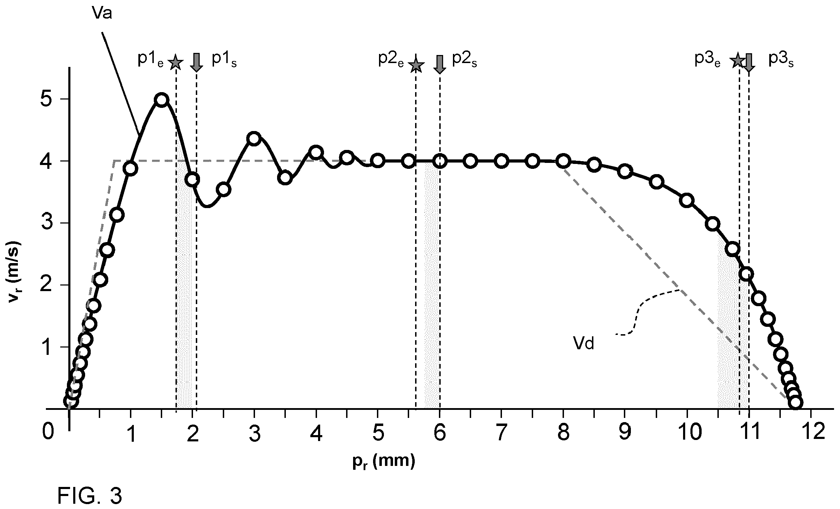

For further increasing a precision of deposition it is taken into account that the velocity with which the relative displacement is performed varies as a function of time. This is illustrated in FIG. 3.

In FIG. 3 the vertical axis indicates the velocity $v_r$ of the carrier 3 relative to the donor plate in m/s and the horizontal axis indicates a position $p_r$ of the object stage relative to the donor plate in mm. The dashed curve indicates a scheduled velocity Vd and the solid curve indicates an actual velocity Va as a function of the traversed distance $p_r$. The open dots indicate measured position/velocity states. In practice, the actual velocity Va deviates from the scheduled velocity Vd due to the mechanical behavior of the carrier and the actuator that actuates the carrier.

In this example, the actuator 4 is controlled to move the carrier 3 relative to the donor plate 2 with a constant acceleration up to a target velocity of 4 m/s and to maintain that velocity until a predetermined relative position of the carrier 3 relative to the donor plate 2 is reached, in this example the relative position of 8 mm. From that position the actuator 4 is controlled to further move the carrier 3 relative to the donor plate 2 with a constant deceleration up to standstill.

In this case it is presumed that the donor plate has a fixed position. For example, supposing that a material M1 is ejected from a position of the donor plate 2 that is opposite a position p1e in the reference system of the carrier, then due to the relative movement of the carrier 3 and the donor plate (2), the material will arrive at the surface of the target at a position p1s that is determined by:

$$p1_s = p1_e + \int_0^{t1_s} v_r(t)\, dt$$

$$t1_s = \frac{d_g}{v_m}$$

Therein

Likewise, the relationship between the positions p2e and p2s as well as the relationship between to p3e and p3s can be computed.

In these computations it can be presumed that the ejected material moves with a constant velocity $v_m$. This can be assumed, because ejection of the material is substantially performed in a pulsewise manner.

The velocity $v_m$ is computed as:

$$v_m = \sqrt{\frac{2E_k}{m}}$$

Therein $E_k$ is the energy used to perform the ejection. For example by supplying a pulse of electric power to a resistive heater layer in the donor plate or by supplying a pulse of optical power to an optical radiation absorbing layer in the heater plate.

The energy Ek is computed as a function of the heatflux settings and the material properties, i.e. the evaporation temperature of the material, absorption, specific evaporation energy and the like.
The mass m is computed as a function of the material density and the average layer thickness.

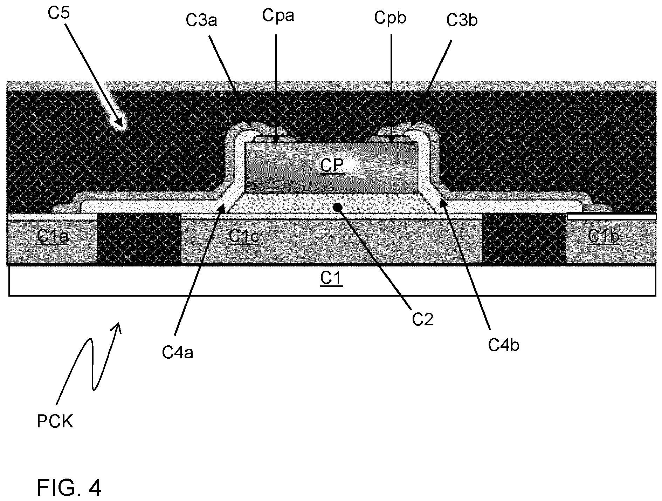

FIG. 4 shows an exemplary product obtainable with the improved deposition device. The exemplary product is a component package PCK comprising a component CP, e.g. a die, on a carrier C1 with electrically conductive tracks C1a, C1b, C1c, for example formed by copper, for example as shown in FIG. 4 with a contact improving coating, e.g. from Ag or Sn. The component CP is adhered to the carrier, in this case with an thermally conductive adhesive C2, such as a silver paste, so as to facilitate heatsinking via the carrier C1 with the track C1b. Electric contacts Cpa, Cpb of the component are electrically connected by electric conductors C3a, C3b to a respective electrically conductive track C1a, C1b. The component CP and electric conductors C3a, C3b are insulated from the electrically conductive track C1c by a dielectric material C4a, C4b. The package is formed in a molding material C5.

In an embodiment the component package PCK is formed with the following steps using a donor plate having on its first main surface respective donor material zones for the materials:

An adhesion/conductivity improvement material Ma;
A dielectric material Mb;
A conductive ink Mc;

During execution of the deposition method first the adhesion/conductivity improvement material Ma is deposited on the area of carrier C 1 with the electrically conductive tracks C1c to form the thermally conductive adhesive C2. Then the component CP is also ejected from a dedicated material zone of the donor plate. This can also be achieved by impulse printing. I.e. a location where the component CP originally is adhered to the donor plate is heated at a temperature exceeding the threshold temperature of the adhesive on the donor plate, so that a resulting vapor pressure ejects the component CP towards the location with the thermally conductive adhesive C2. Then a pattern of dielectric material C4a, C4b is formed by ejecting the dielectric material Mb from its corresponding material zone of the donor plate 2. Subsequently the electric conductors C3a, C3b are formed by ejecting conductive ink Mc from its respective material zone. While performing these deposition processes the carrier C1 is displaced relative to the donor plate in a continuing motion and the point in time of ejection is selected to account for the displacement of the carrier relative to the donor plate while the ejected material traverses the deposition gap.

Subsequent to these deposition steps, the component package PCK is formed by molding the so formed semi-finished product in a molding material.

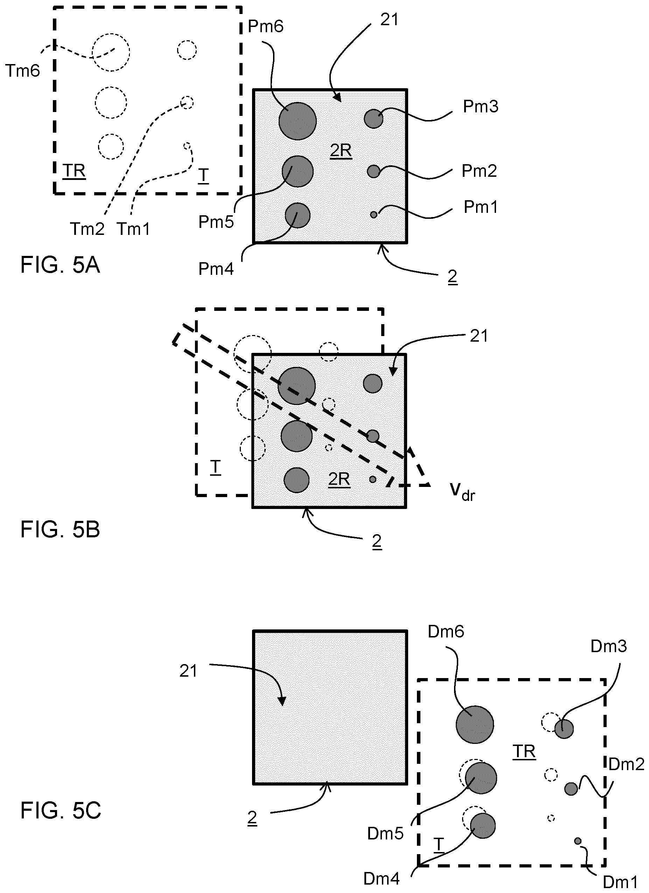

The velocity with which a material is transferred may further depend on a size of the material specimen to be transferred. In practice, the transfer velocity is positively correlated with the size. Larger specimen tend to be transferred at a higher velocity as compared to smaller specimen. This is illustrated in FIG. 5A, 5B, 5C which shows subsequent stages of a pattern of specimen that is being deposited. During the deposition process the target T is moved with a velocity vdr relative to the deposition plate 2, which is held at a fixed position. FIG. 5A-5C show a patterned region 2R of a donor plate and a target region TR of a target where a target pattern is to be formed on the surface, while the target moves with a velocity Vdr relative to the donor plate.

FIG. 5A shows a first situation, wherein the donor plate is provided at its first main surface with the patterned region 2R provided with a donor pattern of donor pattern elements. The donor pattern elements may all be formed from a same material, but may alternatively comprise donor pattern elements of mutually different materials.

In this example a pattern of material species is to be deposited in a single process step to target locations Tm1, Tm2,....,Tm6 on the moving target. FIG. 5A - 5C shows an embodiment not according to the present invention wherein this is attempted to be achieved with a donor plate 2 having the material species Pm1, Pm2,...,Pm6 at lateral positions relative to each other corresponding to the relative positions of the target locations as shown in FIG. 5A. While the target T moves with a velocity vdr relative to the donor plate 2 as shown in FIG. 5B, the donor plate is locally heated in the area with the material species Pm1, Pm2,...,Pm6. However, the conversion of thermal energy into kinetic energy is relatively inefficient for the smaller species than for the larger species, as in case of the smaller species a relatively larger amount of vapor escapes at the boundary at the interface of the species with the donor plate surface 21. As a result, subsequently to the heating step, the smaller species have a relatively low transfer speed in the direction towards the target T than the larger species, Accordingly, as shown in FIG. 5C, the pattern of deposited material species Dm1, Dm2,...,Dm6, formed after completion of the deposition step deviates from the pattern with the species on the donor plate 2.

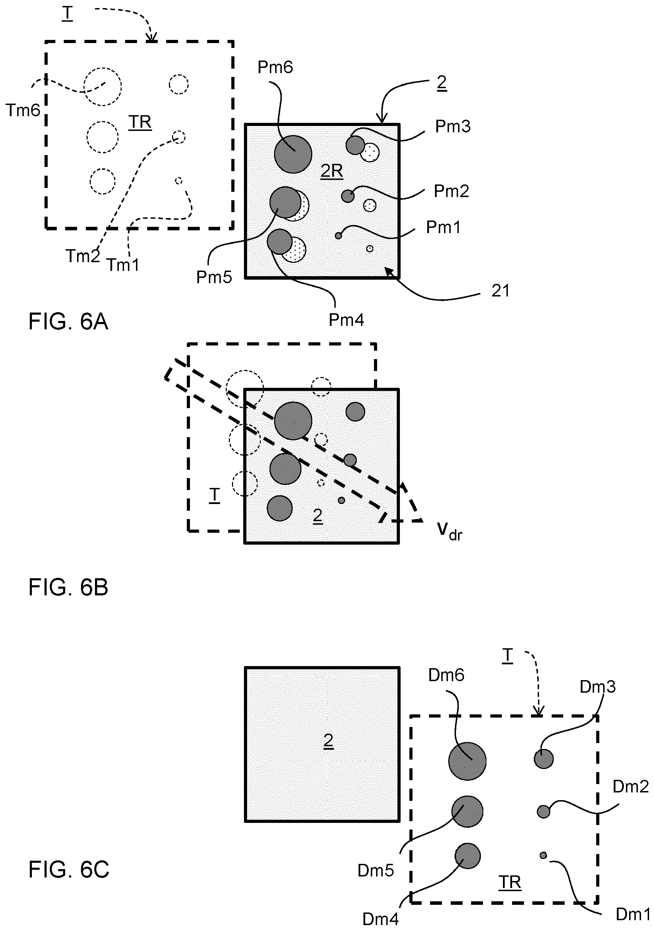

In an embodiment according to the present invention illustrated in FIG. 6A - 6C, this is avoided. To that end the deposition step is preceded by a pattern compensation step. For each material species in a pattern the relative displacement of the target T occurring during the time of transfer of that material species towards the target surface is computed and starting from the desired locations of each species on the target the corresponding positions on the donor plate 2 is computed. Accordingly, if a material species Pmj is to be deposited at a position Tmj, then the position of the species on the plate is computed as

$$Position\ (Pmj) = Tmj + \frac{vdr}{v(Pmj)}dgap$$

Therewith it is achieved that the material species, despite their mutually different transfer times arrive at their predetermined positions in the pattern to be formed, even when they are ejected at the same point in time. This measure is also applicable if the transfer times differ due to different material properties of the material species to be deposited in a single deposition step.

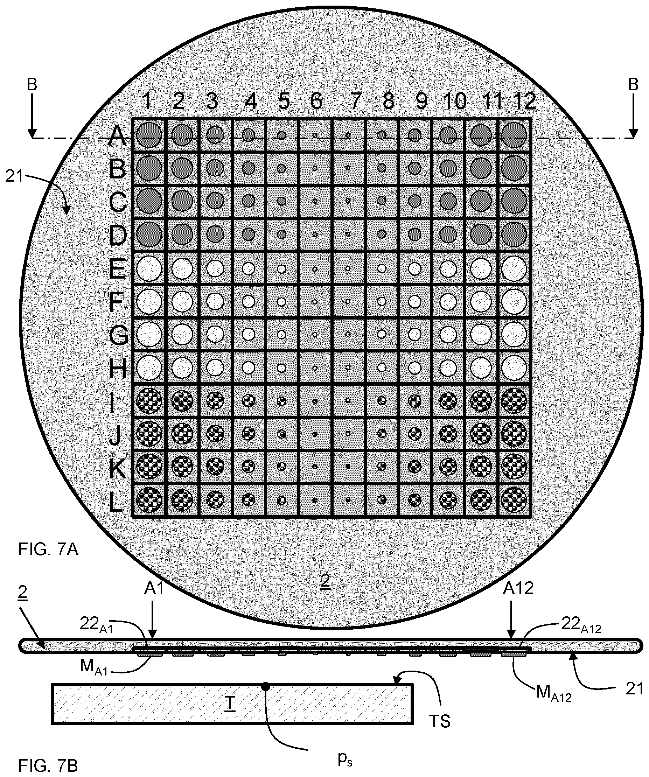

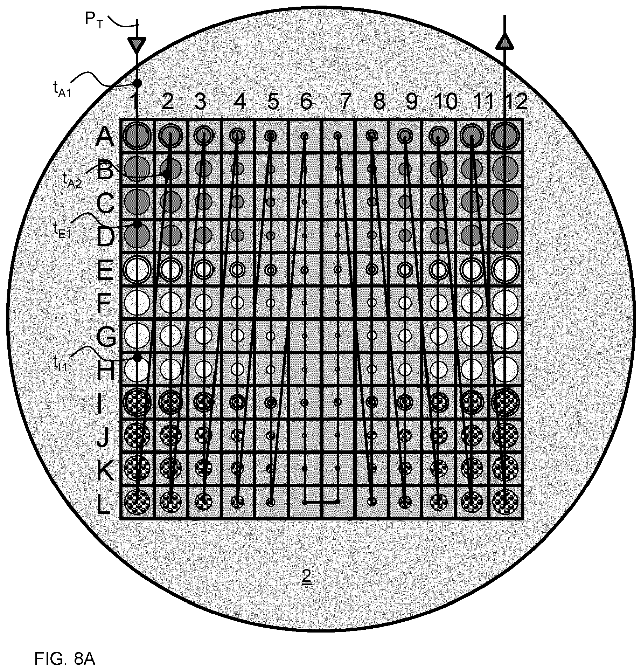

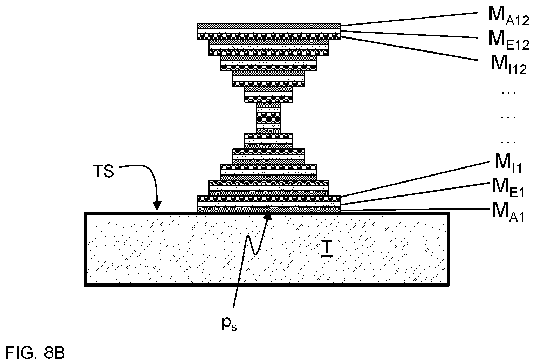

FIG. 7A, 7B and FIG. 8A, 8B show a further application. FIG. 7A shows the main surface 21 of the donor plate 2. As shown in FIG. 7A, in this example, the donor plate 2 comprises a plurality of material zones {A1,...,A12; ...L1,...,L12} arranged as a grid, with rows A-L and columns 1-12, that can be independently heated. FIG. 7B shows the donor plate 2 in a cross-section according to B-B in FIG. 7A and positioned with its main surface 21 opposite a target surface TS of a target T. As shown in FIG. 7B in this example, the material zones A1, ..., L12 each have a respective controllable resistive heater element, e.g. the heater element $22_{A1}$ for the material zone A1 and the heater element $22_{A12}$ for the material zone A12. Alternatively, however, respective material zones may be heated by a controllable heated by a laser beam. The zones may each comprise a respective specimen of a material to be deposited. The material present in each zone is denoted as $M_{xy}$, wherein x, y are the row and column of the zone respectively. In this example the zones in the rows A-D all comprise species of a first material, the zones in the rows E-H all comprise species of a second material, and the zones in the rows I-L all comprise species of a third material. For example, as shown in FIG. 7B the material zone A1 comprises a species of material $M_{A1}$ and the material zone A12 comprises a species of material $M_{A12}$. The size of the species on the donor plate 2 stepwise decreases with the column index 1-6 and stepwise increases again from column index 7 to 12.

In FIG. 8A, the meandering arrow $P_T$ shows a path along which a position $p_s$ on the target T is moved relative to the donor plate 2. At proper points in time a respective material zone is heated to transfer the material from that material zone to the target T to achieve that the ejected material specimen form a stack on a predetermined position $p_s$ on the target surface as shown in FIG. 8B. As shown, the species of material $M_{A1}$ is ejected from the material zone A1 at a point in time $t_{A1}$ before the position $p_s$ is moved below the target zone A1, so that the ejected species of material $M_{A1}$ is deposited in a way centered respective to the location $p_s$ on the target surface. Likewise the species of material $M_{E1}$ is ejected from the material zone E1 at a point in time $t_{E1}$ before the position $p_s$ is moved below the target zone E1, so that the ejected species of material $M_{E1}$ is deposited in a centered manner on the already deposited species of material $M_{A1}$. Similarly the species of material $M_{I1}$ is timely ejected from the material zone I1. Then the procedure continues with the ejection of the smaller species $M_{A2}$ from material zone A2 at point in time $t_{A2}$ to achieve that the species $M_{A2}$ lands on the deposited layer of the species $M_{I1}$. The procedure continues until the species $M_{A12}$ has been deposited as the final layer of the stack.

Subsequently, a second stack can be built by depositing the material species in the material zones of the rows B, F and J, a third stack with the material species in the material zones of the rows C, G and K and a fourth stack with the material species in the material zones of the rows D, H and L. Also other types of stacks can be obtained by a corresponding selection of material zones and the corresponding times of ejection. For example if a stack is desired with all layers of the same size, the movement of the target T is controlled to move with the stack position $p_s$ in a back and forward direction along a single column having the material species with the desired size. For example, the selected row is 4 and subsequently the material species in the zones A4, E4, I4, B4, F4, J4, C4, G4, K4, D4, H4 and J4 are ejected each a point in time so that the ejected material species are deposited at the stack position $p_s$.

In the application discussed with reference to FIG. 7A, 7B, 8A and 8B, the material zones have a fixed size, while the material species have mutually different sizes. In this case the relatively small species has a relatively high transfer speed as compared to the larger species for a predetermined power density. This can be explained by the fact that in case the material species completely covers the material zone, then the power density with which that species is heated is about the same as the power density of the material zone. However, if the species covers a smaller portion of the material zone, than the power induced in the portion of the material zone outside the portion covered by the species partly flows to the portion covered with the species. Therewith the power density in the latter portion is somewhat higher.

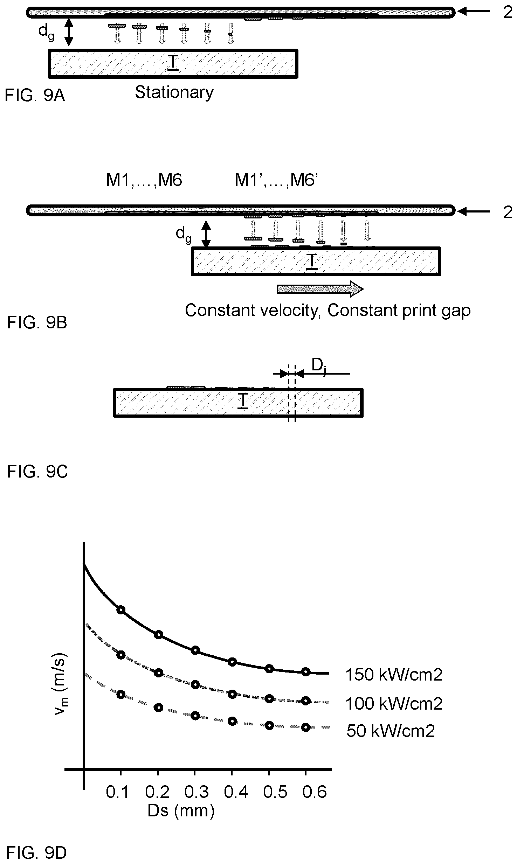

FIG. 9A-9D illustrate a measurement method for measuring the transfer velocity of the material species M1, ...,M6 in accordance with their size. Also the dependency on other features of the species can be determined, e.g. a material it is composed of, a shape of the material species and the like. First, as shown in FIG. 9A a first set of material species M1,...,M6 having mutually different sizes Ds are ejected with the target stationary positioned opposite the donor plate 2. Second, as shown in FIG. 9B a second set of material species M1',...,M6' are ejected with the target T moving at a constant relative velocity $v_r$, and at a constant print gap $d_g$, relative to the donor plate (2). In this second step the heater elements are simultaneously activated once the earlier deposited material species M1,...,M6 are exactly opposite the to be ejected material species M1',...,M6'. Subsequently, as shown in FIG. 9C, the distance $D_k$ between a deposition position of each ejected material species M1',...,M6' and its respective earlier deposited material species M1,...,M6 is measured.

The transfer velocity $v_{mk}$ for a specific material species Mk can then be computed as:

$$v_{mk} = \frac{D_k}{d_g} v_r$$

Therewith the dependency of the transfer velocity $v_m$ can be determined as a function of the specimen size and the power density with which heat is supplied in a material zone. As shown in FIG. 9D, a continuous monotonously decreasing relationship may be assumed for the transfer velocity as a function of the size Ds of the species. Therewith it suffices to perform the measurements for a limited number of sizes and the transfer velocity for species of a deviating sizes can be estimated by interpolation. Furthermore, a continuous monotonously increasing relationship may be assumed for the transfer velocity as a function of the power density. Hence, likewise it suffices to perform the measurements for a limited number of power density values, and the transfer velocity for intermediate power densities can be estimated by interpolation. It is noted that in this case it is presumed that the material species are provided in a laterally symmetrical shape. The measurement can analogously be extended to other shapes.

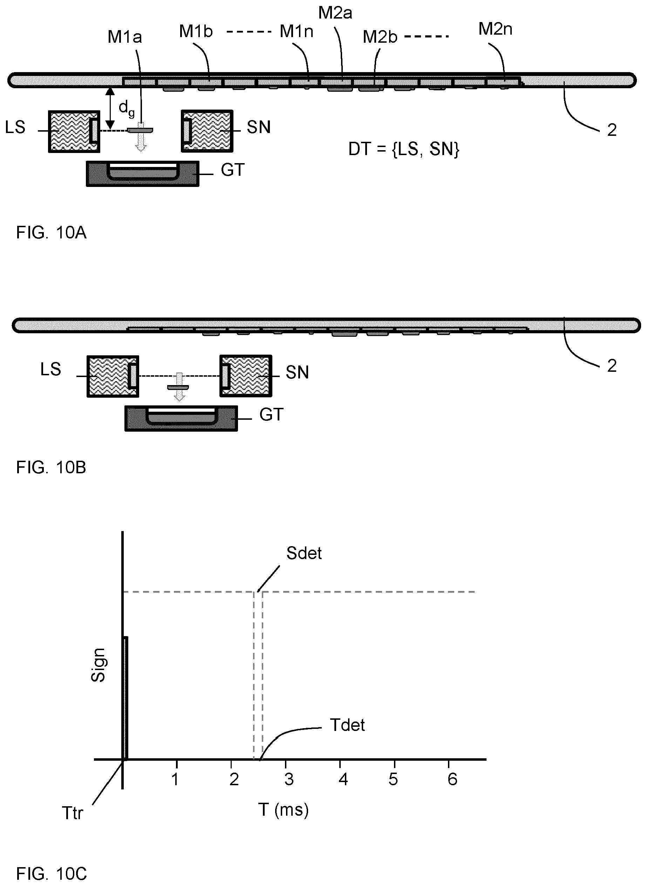

FIG. 10A, 10B and 10C illustrate an alternative approach to measure the transfer velocity as a function and the power density with which the material zone comprising the specimen is heated and of properties of the specimen to be transferred, e.g. its size, the type of material it is constituted of and the like. Likewise, in this approach a donor plate 2 is provided with a plurality of material species M1a,M1b,...,M1n; M2a, M2b,...M2n, in respective locally heatable material zones. By way of example M1a,M1b,...,M1n are species of different sizes of a first material M1 and M2a, M2b,...M2n are species of different sizes of a second material M2.

The donor plate 2 is positioned in front of a detector DT that issues a detection pulse Sdet (See FIG. 10C) when a species of material, e.g. M1a, has traversed a gap distance $d_g$. FIG. 10A shows the measuring arrangement at a point in time Ttr that traversal of the species M1a is detected. FIG. 10B shows the measuring arrangement at a subsequent point in time. When the detection pulse Sdet is issued the transfer velocity $v_m$ can be calculated as:

$$v_m = \frac{d_g}{T_{det} - T_{tr}}$$

Wherein further, Ttr is the point in time that the species was ejected. The ejected material is collected in gutter GT. In the example shown, the detector DT is a laser (LS) / sensor (SN) combination. Alternative examples are a capacitive and an inductive sensor.

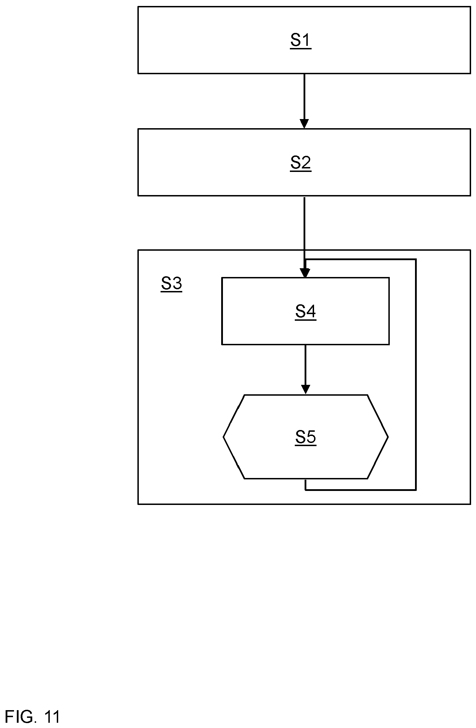

FIG. 11 schematically shows a deposition method for depositing materials. The method comprises a step S1 of providing a deposition schedule that specifies a pattern of deposition positions ps where specimen of the materials are to be deposited on the target. The deposition schedule may specify a respective positions at which the specimen are to be deposited directly on the target surface TS. However, the deposition schedule may additionally specify a vertical position, i.e. an order in which two or more specimen are to be stacked on the target surface TS.

In step S2 a donor plate 2 is provided that has a first main surface 21 cladded with the materials of which specimen are to be deposited. The materials may be provided in material areas, from which specimen are ejected by locally heating a portion of the material area. Alternatively the specimen to be ejected are provided distinct from each other. In some examples a plurality of mutually distinct specimen, in a pattern area, for example specimen of mutually different materials is ejected simultaneously by heating the pattern area.

In operation the target and the donor plate are controllably displaced, indicated as step S3, relative to each other while a target surface TS of the target T faces the first main surface 21 of the donor plate 2 at a gap distance dg thereof.

In step S4, which is performed while the target and the donor plate are controllably displaced relative to each other, the heater facility 22 is controllably activated for each specimen to be deposited in accordance with the deposition schedule. The heater facility controllably activated to eject the specimen from an ejection position pe of the donor plate 2 at a point in time that a spatial vector defined between the deposition position ps specified for the specimen and the ejection position pe corresponds to the relative movement Δl, occurring as a result of controllably displacing the target and the donor plate in a time interval wherein the ejected specimen traverses the gap distance dg.

As noted above, in some examples, a plurality of mutually distinct material species may be provided in a common controllably heatable zone of the first main surface of the donor plate. This implies that the material species are simultaneously ejected. In practice the material species may however be ejected with mutually different velocities dependent on their size and/or their material properties. As a consequence the pattern in which the species are deposited on the target surface differs from the pattern in which the species were provided in the common controllably heatable zone. In an embodiment the improved method comprises a donor plate preparation step, wherein the positions of each of the mutually distinct material species on the donor plate are computed based on the pattern of deposition positions ps with which they are to be deposited on the target surface TS of the target T and a respective expected transfer velocity of said ejected species. The expected transfer velocity of a species can be predicted based on data about properties like size, shape and material properties of the species. In one approach transfer of a species with the same properties is simulated to determine the expected transfer velocity. In another approach the expected transfer velocity is determined experimentally with test samples. Additionally the expected transfer velocity may be predicted on the basis of interpolation of transfer velocity estimations from simulations or from tests. It may be the case that a distortion of a species occurs during its transfer, so that the shape of the deposited species differs from its original shape on the donor plate. By simulation or test procedures it can be determined with which shape of the species on the donor plate the shape of the transferred species optimally approaches a desired shape. Also in this case results from simulation or test procedures can be interpolated.

It is noted that alternatively the point in time of ejection may be delayed relative to the point in time that a heating pulse is supplied by providing a thermal buffer layer between the first main surface and the species to be ejected. As a result of the thermal buffer layer the transfer of heat to the species is delayed, so as to compensate a relatively high transfer velocity of a species. The thermal buffer layer is a thin layer of a thermally insulating material, e.g. a ceramic layer (e.g. SiO2 or TiO2) having a thickness in the order of 0.1 to 10 micron. The donor plate preparation obviates the necessity of a thermal buffer layer pattern for compensating transfer velocity differences. Nevertheless, it may be contemplated to combine these approaches of deposition position adaptation in the donor plate preparation step and transfer velocity compensation by applying thermal buffer layer elements.

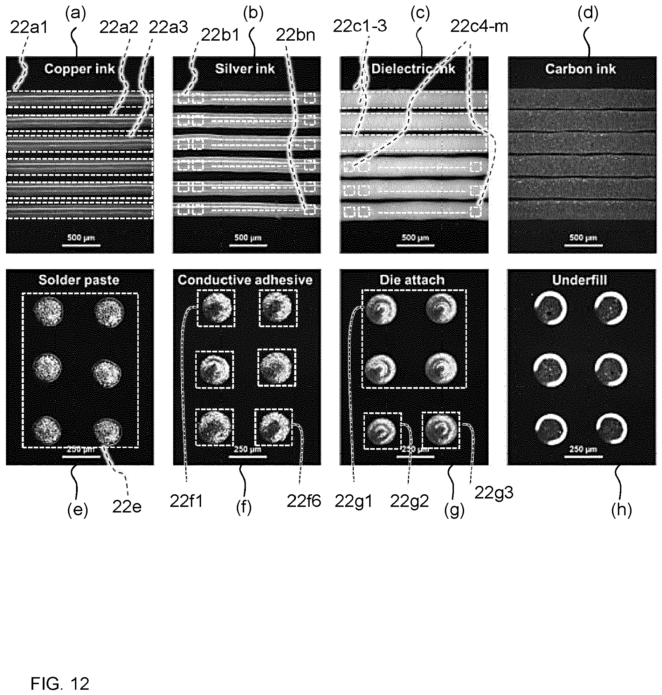

FIG. 12 shows exemplary examples of a first main surface or portion thereof of a donor plate provided with materials to be deposited.

Example a) shows a donor plate surface provided with stripes of a copper ink, e.g. a suspension of copper particles in a suspension agent. The stripes have a width of about 150 micron and a length of about 2 mm. In this example the heater facility comprises a plurality of individually addressable resistive heater layer elements 22a1, 22a2, 22a3,... provided in a resistive heater layer below the first main surface of the donor plate. Each individually addressable resistive heater layer element is provided below a respective stripe. Therewith, during operation, a selected stripe of copper ink can be individually ejected towards the target by resistively heating its corresponding resistive heater layer element with a pulse of electric power. Alternatively it is also possible to eject two or more or all stripes by resistively heating their corresponding resistive heater layer elements simultaneously.

Example b) shows a donor plate surface provided with stripes of a silver ink, e.g. a suspension of silver particles in a suspension agent. In this example the heater facility comprises a plurality of individually addressable resistive heater layer elements 22b1, ..., 22bn provided in a resistive heater layer below the first main surface of the donor plate. The resistive heater layer elements 22b1, ..., 22bn are tile-shaped with a size of about 150x150 micron. Each stripe has a corresponding subset of the resistive individually addressable resistive heater layer elements.

Therewith, when resistively heating a selected one of the resistive heater layer elements with a pulse of electric power a specimen of the silver ink in a surface area of the donor plate corresponding to that of the resistively heated heater layer element is ejected towards the target. Alternatively it is also possible to simultaneously eject two or more specimen by resistively heating their corresponding resistive heater layer elements simultaneously.

Example c) shows a donor plate surface provided with stripes of a dielectric ink, e.g. a suspension of particles of a dielectric material, such as a ceramic material like $SiO_2$ or $TiO_2$ in a suspension agent. In this example the heater facility plurality of individually addressable resistive heater layer elements comprise line shaped resistive heater elements 22c1-3, and also tile shaped resistive heater elements 22c4-m provided in a resistive heater layer below the first main surface of the donor plate. Therewith it is possible to eject one or more individual lines of the dielectric ink as described for example a) and/or to eject one or more specimen of the dielectric ink as described for example b).

Example d) shows a donor plate surface provided with stripes of a carbon ink, e.g. a suspension of particles of carbon in a suspension agent. The donor plate may have a heater facility as specified for example a), b) or c). It is noted that in any of the donor plate examples any type of donor material may be provided with any implementation of the heater facility.

Example e) shows a donor plate surface provided with mutually distinct specimen of a solder of a carbon ink, e.g. the solder based on SAC305 as specified above. In this example the heater facility comprises a common addressable resistive heater layer element 22e provided in a resistive heater layer below the area of the first main surface of the donor plate which is provided with the solder specimen. When resistively heating the resistive heater layer element 22e with a pulse of electric power the solder specimen in that area are simultaneously ejected towards the target.

Example f) shows a donor plate surface provided with mutually distinct specimen of a conductive adhesive, e.g. an adhesive material containing conductive particles, e.g. metal particles. The heater facility comprises a respective individually addressable resistive heater layer element 22f1,...,22f6 provided in a resistive heater layer below each sub-area provided with a conductive adhesive specimen. When resistively heating a selected one of the individually addressable resistive heater layer elements 22f1,..., 22f6 with a pulse of electric power the conductive adhesive specimen in the corresponding sub-area is ejected towards the target. Alternatively, two or more or all of the conductive adhesive specimen can be ejected simultaneously by simultaneously providing a pulse of electric power to their associated individually addressable resistive heater layer elements.

Example g) shows a donor plate surface provided with mutually distinct specimen of a die attach material, such as an electrically insulating, but thermally well conducting adhesive material. In this example the heater facility comprises a common addressable resistive heater layer element 22g1 provided in a resistive heater layer below an area of the first main surface of the donor plate which is provided with four specimen of the die attach material. The heater facility also comprises a respective individually addressable resistive heater layer element 22g2, 22g3 provided in a resistive heater layer below each sub-area provided with a single specimen of the die attach material. Therewith it is possible to eject four die attach specimen simultaneously by providing a pulse of electric power to the common addressable resistive heater layer element 22g1. Alternatively die attach specimen can be ejected individually by providing a pulse of electric power to a selected one of the individually addressable resistive heater layer elements 22g2, 22g3. Other options are to simultaneously provide a pulse of electric power to two or more of the common addressable resistive heater layer element 22g1 and the individually addressable resistive heater layer elements 22g2, 22g3.

Example h) shows a donor plate surface provided with mutually distinct specimen of an underfill material, such as Henkel EP3RRLV. Regardless the donor material to be provided on the first main surface of the donor plate, the heater facility may be implemented in various ways, as is illustrated in the examples e) to g).

It is noted that a donor plate may be provided with sub-areas according to a combination of two or more or all of the examples a) to h).

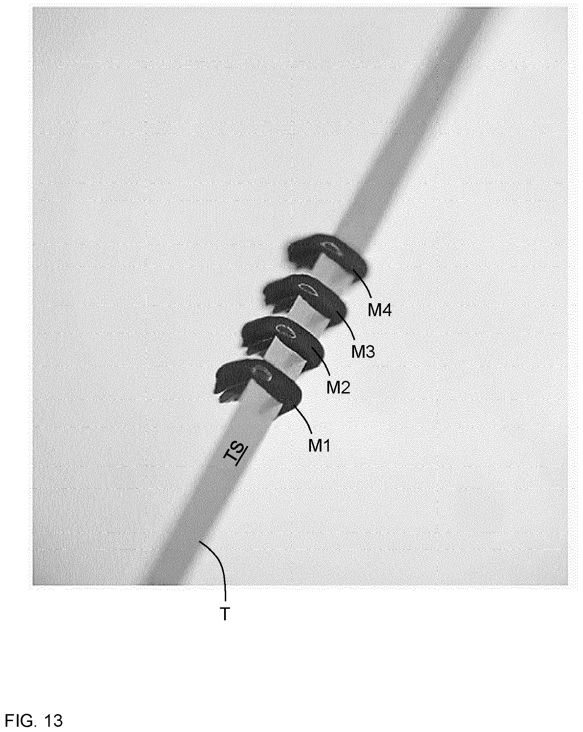

FIG. 13 shows an example wherein the target surface TS is a region including an edge and its surrounding bottom and top surface of a glass plate T. With the donor plate shown in example a) of FIG. 12 stripes of copper ink were deposited on the edge. Upon hitting the surface of the edge, the stripes of copper ink folded over the bottom and top surface. This process was repeated so that electrical conductors M1, M2, M3, M4 were formed that each form an electric connection between electronic circuitry on the bottom surface and electronic circuitry on the top surface. Each of the electrical conductors M1, M2, M3, M4 is formed as a stack of copper ink stripes.

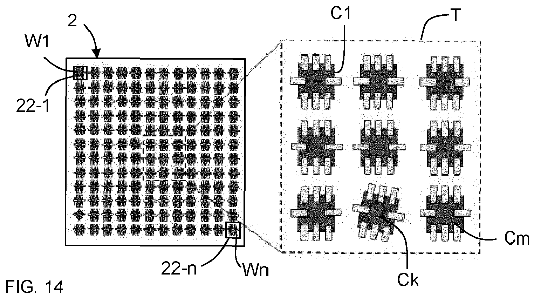

FIG. 14 shows an application wherein the target T is a carrier with a plurality of components C 1,...,Cm to be wire bonded. This is achieved with a donor plate 2 with a plurality of wire patterns W1,...,Wn, each comprising a pattern of lines of an electrically conductive ink and each being provided in a sub-area with an individually addressable resistive heater layer element 22-1,...,22-n. As shown in the right part of FIG. 14, the components C1,...,Cm to be wire bonded are not all perfectly aligned. For example, the component Ck has a clearly deviating orientation. In an exemplary embodiment of the improved deposition device the displacement unit 4 for displacing the carrier and the donor plate relative to each other is further configured to dynamically change an orientation of the donor plate 2 relative to the target T around a rotation axis transverse to the main surface of the donor plate. In operation, the controller dynamically adapts the orientation of the donor plate 2 relative to the target T in accordance with the orientation of the component where a pattern of lines is to be deposited. Therewith it is achieved that despite a component is provided with aligned wirebonds even if the component is not aligned on the carrier. In an embodiment of the method, the components to be wirebonded are first grouped into alignment sets, wherein each alignment set comprises components having substantially the same misalignment. For each alignment set the wirebonding process is performed with a common orientation of the donor plate 2 relative to the target T in accordance with the average misalignment of the component in the alignment set. Therewith the wirebonding process can be performed very efficiently even if the carrier has misaligned components.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

**Claims**

1. A deposition apparatus (1) for depositing materials (Ma, Mb, ..., Mn) on a target (T), the apparatus comprising:

   a donor plate (2) having a first main surface (21) coated with said materials;
   a heater facility (22) for locally heating an area of the first main surface (21) so as to eject material present on the first main surface in said area towards the target;
   a carrier (3) for carrying the target (T) with a target surface (TS) facing the first main surface (21) of the donor plate (2) at a gap distance (dg) thereof;
   a displacement unit (4) for displacing the carrier and the donor plate relative to each other;
   a storage unit (5) for storing a deposition schedule that specifies a pattern of deposition positions ($p_s$) where material portions of said materials (Ma, Mb, ..., Mn) are to be deposited on the target surface (TS);
   a controller (6) for controlling the heater facility (22) and the displacement unit (4), the controller (5) being configured to:
   read the deposition schedule;
   for each material portion to be deposited perform the following steps:

      determine an ejection position ($p_e$) of the donor plate (2) where the material portion to be deposited is present,
      determine a velocity ($v_{dt}$) of a relative movement between the donor plate (2) and the target (T),
      compute a resulting relative movement ($\Delta l$) occurring in a time interval wherein the ejected material portion traverses the gap distance (dg) based on said velocity and a velocity with which said material portion is ejected;
      initiating ejection of the material portion from the ejection position of the donor plate (2) at a point in time that a spatial vector defined between the deposition position ($p_s$) and the ejection position ($p_e$) corresponds to the relative movement.

2. The deposition apparatus according to claim 1, wherein the heater facility (22) is configured for locally heating the donor plate in a region comprising a plurality of mutually distinct material species.

3. The deposition apparatus according to claim 2, wherein the mutually distinct material species comprise at least two species of a mutually different material.

**4.** The deposition apparatus according to claim 2 or 3, wherein the mutually distinct material species comprise at least two species of a mutually different size and/or shape.

**5.** The deposition apparatus according to any of the preceding claims, wherein the heater facility (22) is configured for locally heating the donor plate in a region being a portion of a larger region with a uniform layer of a single material.

**6.** The deposition apparatus according to claim 1, wherein the deposition pattern further specifies an order in which material portions are to be stacked on the target surface (TS) and wherein the controller (5) is configured to control the deposition apparatus to perform deposition in said order.

**7.** The deposition apparatus according to any of the claims 1 to 6, wherein the heater facility comprises a resistive heater layer (22) which is partitioned into individually controllable resistive heater layer sections and an electric power source (7) controlled by said controller (6) for supplying an electric power to selected ones of said resistive heater layer sections.

**8.** The deposition apparatus according to any of the claims 1 to 6, wherein the heater facility comprises a photon radiation source that is controlled by said controller to direct a beam of photon radiation to selected positions of the donor plate.

**9.** The deposition apparatus according to any of the preceding claims, configured to simultaneously heat a region of the donor plate that comprises a pattern of one or more of the materials (Ma, Mb, ..., Mn) to be deposited,

**10.** A deposition method for depositing materials (Ma, Mb, ..., Mn) on a target (T), comprising:

providing (S1) a deposition schedule that specifies a pattern of deposition positions (ps) where specimen of said materials (Ma, Mb, ..., Mn) are to be deposited on the target (T);
providing (S2) a donor plate (2) having a first main surface (21) coated with said materials,
controllably displacing (S3) the target and the donor plate relative to each other while a target surface (TS) of the target (T) faces the first main surface (21) of the donor plate (2) at a gap distance (dg) thereof;
while controllably displacing, controlling (S4) the heater facility (22) for each specimen to be deposited in accordance with the deposition schedule to eject the specimen from an ejection position (pe) of the donor plate (2) at a point in time that a spatial vector defined between the deposition position (ps) specified for the specimen and the ejection position (pe) corresponds to the lateral movement (Δl) occurring in a time interval wherein the ejected specimen traverses the gap distance (dg).

**11.** The method according to claim 10, wherein the donor plate (2) is provided with a plurality of mutually distinct material species in donor plate zone, and wherein the plurality of mutually distinct material species is ejected simultaneously by heating said donor plate zone.

**12.** The method according to claim 11, comprising a donor plate preparation step, wherein the positions and/or shapes of each of the mutually distinct material species on the donor plate are computed based on the pattern of deposition positions (ps) and/or shapes with which they are to be deposited on the target surface (TS) of the target (T) and on a respective expected transfer velocity of said ejected species which is predicted in accordance with their size and/or shape and/or material properties.

**13.** A method for packaging a die (CP) in a chip package (PCK):

printing an adhesion/conductivity improvement material (C2) on a carrier (C 1);
placing the die (CP) on the printed adhesion/conductivity improvement material (C2);
printing a dielectric material (C4a, C4b) to insulate the sides of the die and a gap between electric contacts (Cpa, Cpb) of the die and respective external electric contacts (C1a, C1b) to be electrically connected with the electric contacts of the die;
printing a conductive ink (C3a, C3b) on top of the dielectric material to electrically connect the electric contacts of the die with the respective external electric contacts;
printing a mould compound (C5) to form an encapsulation of the die by the mold compound and the carrier, therewith forming the chip package (PCK);
wherein one or more of the printing steps is performed with the method according to claim 10.

**14.** The deposition method according to claim 10, wherein the deposition schedule comprises a target pattern with two or more target pattern elements to be formed by depositing one or more of the materials (Ma, Mb, ..., Mn) on the target surface, the method comprising

providing a donor plate (2) having at its first main surface (21) a patterned region (2R) with a donor pattern of donor pattern elements each corresponding to a respective one of the target pattern elements and comprising the material of the corresponding target pattern element to be formed;

while moving the donor plate (2) and the target (T) relative to each other integrally heating the patterned region of the donor plate to simultaneously eject donor pattern elements to the target surface to form the respective target pattern elements of the target;

wherein providing the donor plate (2) comprises determining respective positions of the donor pattern elements in the donor pattern in accordance with the respective positions of the target pattern elements in the target pattern to be formed and the respective expected time of transfer of each donor pattern element to the target surface dependent on the material of which it is composed and its size.

15. The deposition method according to claim 10, comprising dynamically changing an orientation of the donor plate (2) relative to the target (T) around a rotation axis transverse to the main surface (21) of the donor plate (2) to therewith adapt the orientation of the donor plate (2) relative to the target (T) in accordance with the orientation of a component (Ck) where a pattern of lines is to be deposited for wire-bonding.

FIG. 1

FIG. 2A

FIG. 2B

FIG. 3

FIG. 4

FIG. 5A

FIG. 5B

FIG. 5C

FIG. 6A

FIG. 6B

FIG. 6C

FIG. 7A

FIG. 7B

FIG. 8A

$M_{A12}$

$M_{E12}$

$M_{I12}$

$\cdots$

$\cdots$

$\cdots$

$M_{I1}$

$M_{E1}$

$M_{A1}$

TS

$\underline{T}$

$p_s$

FIG. 8B

$d_g$

FIG. 9A          Stationary

M1,...,M6          M1',...,M6'

$d_g$

FIG. 9B          Constant velocity, Constant print gap

$D_j$

FIG. 9C

$v_m$ (m/s)

150 kW/cm2

100 kW/cm2

50 kW/cm2

0.1  0.2  0.3  0.4  0.5  0.6
Ds (mm)

FIG. 9D

M1a  M1b ----- M1n  M2a  M2b ----- M2n

LS

$d_g$

SN

GT

DT = {LS, SN}

2

FIG. 10A

LS

SN

GT

2

FIG. 10B

Sdet

Sign

Tdet

1    2    3    4    5    6

Ttr

T (ms)

FIG. 10C

FIG. 11

FIG. 12

FIG. 13

FIG. 14

Europäisches
Patentamt

European
Patent Office

Office européen
des brevets

**EUROPEAN SEARCH REPORT**

Application Number

EP 23 15 1545

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 666 169 A (UNIV NANJING AGRICULTURAL) 10 January 2020 (2020-01-10) | 1-11,13, 15 | INV.<br>C23C14/04 |
| A | * Fig.1, claims 1,2; 6 of the machine translation; Examples * | 12,14 | C23C14/54<br>C23C14/26<br>C23C14/28 |
| A | JP 2021 130302 A (RICOH CO LTD) 9 September 2021 (2021-09-09) * Fig. 6, 76 * | 1-15 | C23C14/16<br>C23C14/08<br>B33Y10/00<br>B33Y30/00 |
| A | US 2021/094232 A1 (SUHARA HIROYUKI [JP] ET AL) 1 April 2021 (2021-04-01) * Figs. 12, 15, 16; 144- 148, 194- 197 * | 1-15 | B29C64/00<br>H05K3/04<br>H01L21/26<br>H01L23/00 |
| X | WO 00/72224 A1 (POTOMAC PHOTONICS INC [US]; DUIGNAN MICHAEL T [US]) 30 November 2000 (2000-11-30) | 1-11,13, 15 | B23K26/00<br><br>ADD. |
| A | * claims 1,8, 13; Figs. 1-4,6,7,8, 12, pg. 7 l. 2-9, pg. 26 l. 17-pg. 30 l. 7; pg. 1 l. 15-20, pg. 3 l. 13-15 * | 12,14 | H05K1/09<br>H05K3/40 |
| A | EP 3 911 130 A1 (TNO [NL]) 17 November 2021 (2021-11-17) * the whole document * | 1-15 | **TECHNICAL FIELDS SEARCHED (IPC)**<br><br>B33Y<br>B29C |
| A | EP 3 902 380 A1 (TNO [NL]) 27 October 2021 (2021-10-27) * the whole document * | 1-15 | H05K<br>C23C<br>H01L |
| A | PERE SERRA ET AL: "Laser-Induced Forward Transfer: Fundamentals and Applications", ADVANCED MATERIALS TECHNOLOGIES, vol. 4, no. 1, 8 August 2018 (2018-08-08), page 1800099, XP055597607, DE ISSN: 2365-709X, DOI: 10.1002/admt.201800099 * the whole document * | 1-15 | |

-/--

The present search report has been drawn up for all claims

| Place of search | Date of completion of the search | Examiner |
|---|---|---|
| The Hague | 18 July 2023 | Abrasonis, Gintautas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 23 15 1545

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZACHARATOS FILIMON ET AL: "Laser-Induced Forward Transfer (LIFT) Technique as an Alternative for Assembly and Packaging of Electronic Components", IEEE JOURNAL OF SELECTED TOPICS IN QUANTUM ELECTRONICS, IEEE, USA, vol. 27, no. 6, 27 May 2021 (2021-05-27), pages 1-8, XP011863528, ISSN: 1077-260X, DOI: 10.1109/JSTQE.2021.3084443 [retrieved on 2021-06-29] * the whole document * ----- | 1-15 | |
| A | US 2019/043734 A1 (KAPUSTA CHRISTOPHER JAMES [US] ET AL) 7 February 2019 (2019-02-07) * the whole document * ----- | 1-15 | |
| | | | TECHNICAL FIELDS SEARCHED (IPC) |

The present search report has been drawn up for all claims

| Place of search | Date of completion of the search | Examiner |
|---|---|---|
| The Hague | 18 July 2023 | Abrasonis, Gintautas |

EPO FORM 1503 03.82 (P04C01)

**ANNEX TO THE EUROPEAN SEARCH REPORT
ON EUROPEAN PATENT APPLICATION NO.**

EP 23 15 1545

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2023

| Patent document cited in search report | | Publication date | Patent family member(s) | | Publication date |
|---|---|---|---|---|---|
| CN 110666169 | A | 10-01-2020 | NONE | | |
| JP 2021130302 | A | 09-09-2021 | NONE | | |
| US 2021094232 | A1 | 01-04-2021 | EP | 3800033 A1 | 07-04-2021 |
| | | | US | 2021094232 A1 | 01-04-2021 |
| WO 0072224 | A1 | 30-11-2000 | AU | 5122800 A | 12-12-2000 |
| | | | EP | 1099183 A1 | 16-05-2001 |
| | | | WO | 0072224 A1 | 30-11-2000 |
| EP 3911130 | A1 | 17-11-2021 | CN | 115700015 A | 03-02-2023 |
| | | | EP | 3911130 A1 | 17-11-2021 |
| | | | EP | 4151057 A1 | 22-03-2023 |
| | | | JP | 2023525815 A | 19-06-2023 |
| | | | KR | 20230008802 A | 16-01-2023 |
| | | | WO | 2021230746 A1 | 18-11-2021 |
| EP 3902380 | A1 | 27-10-2021 | CN | 115700013 A | 03-02-2023 |
| | | | EP | 3902380 A1 | 27-10-2021 |
| | | | EP | 4140262 A1 | 01-03-2023 |
| | | | JP | 2023523005 A | 01-06-2023 |
| | | | KR | 20230008131 A | 13-01-2023 |
| | | | US | 2023209722 A1 | 29-06-2023 |
| | | | WO | 2021215929 A1 | 28-10-2021 |
| US 2019043734 | A1 | 07-02-2019 | US | 2019043734 A1 | 07-02-2019 |
| | | | WO | 2019027695 A1 | 07-02-2019 |

EPO FORM P0459

For more details about this annex : see Official Journal of the European Patent Office, No. 12/82